# DEMANDE DE BREVET EUROPEEN

(11) **EP 3 809 450 A1**
(43) Date de publication de la demande: **21.04.2021**
(21) Numéro de dépôt: 20201243.1
(22) Date de dépôt: 12.10.2020
(51) Int. Cl.: H01L 21/20

(54) **PROCEDE D'HETERO-INTEGRATION D'UN MATERIAU SEMI-CONDUCTEUR D'INTERET SUR UN SUBSTRAT DE SILICIUM**

(30) Priorité: 15.10.2019 FR 1911447
(71) Demandeur: Commissariat à l'Energie Atomique et aux Energies Alternatives, 75015 Paris (FR); Centre National de la Recherche Scientifique, 75016 Paris (FR); Université Grenoble Alpes, 38401 Saint-Martin-d'Hères (FR)
(72) Inventeur: MARTIN, Mickaël, 38000 GRENOBLE (FR); BARON, Thierry, 38120 SAINT-EGREVE (FR); LOUP, Virginie, 38054 GRENOBLE CEDEX 09 (FR)
(74) Mandataire: Marks & Clerk France

(57) **Abrégé**

L'invention concerne un procédé d'hétéro-intégration d'un matériau semi-conducteur d'intérêt sur un substrat (1) de silicium comprenant :
- une étape de structuration du substrat qui comprend une étape de réalisation d'un masque de croissance (2) à la surface du substrat (1) de silicium, ledit masque de croissance comprenant une pluralité de motifs de masquage (20), deux motifs de masquage étant séparés par une tranchée (21) dans laquelle le substrat (1) de silicium est découvert ;
- une étape de formation d'une couche tampon (5) bidimensionnelle en un matériau 2D, ladite couche tampon étant exempte de liaisons pendantes sur sa surface libre et étant formée sélectivement sur au moins un plan (3) de silicium d'orientation [111] dans au moins une tranchée (21), ladite étape de formation d'une couche tampon étant réalisée après l'étape de structuration ;
- une étape de formation d'au moins une couche (61, 62) d'un matériau semi-conducteur d'intérêt sur la couche tampon (5).

Le matériau semi-conducteur d'intérêt est de préférence un matériau semi-conducteur IV-IV, III-V, II-VI et/ou un matériau semi-conducteur 2D.

## Description

### Domaine technique de l'invention

L'invention se situe dans le domaine de l'hétéro-intégration de matériaux semi-conducteurs sur substrat de silicium, et concerne plus précisément l'hétéro-intégration monolithique de semi-conducteurs (IV-IV, III-V, II-VI, matériaux 2D...) par épitaxie sur substrat de silicium.

Parmi les nombreuses applications de l'invention, on peut citer la microélectronique, la photonique, les capteurs, les technologies en relation avec la radiofréquence, les microsystèmes (MEMS), les composants pour l'Internet des objets (Internet of Things) et plus largement tout ce qui touche aux applications « more than Moore » ou technologies dites dérivées, c'est-à-dire les technologies qui intègrent plusieurs fonctions sur une même puce de silicium.

### Etat de la technique

Le silicium (Si) est le semi-conducteur le plus répandu dans les applications de la technologie de l'information et domine l'industrie microélectronique et nanoélectronique. Sa technologie hautement mature pour la fabrication de circuits intégrés (IC) a connu des progrès impressionnants en termes de miniaturisation et d'amélioration des performances.

Par ailleurs, d'autres semi-conducteurs comme les semi-conducteurs IV-IV, III-V, II-VI, matériaux 2D peuvent présenter des propriétés électroniques et/ou optiques complémentaires au silicium.

Les semi-conducteurs IV-IV sont des semi-conducteurs composites fabriqués à partir de plusieurs éléments de la colonne IV du tableau périodique des éléments, par exemple : Si, Ge, C. Comme exemples de semi-conducteurs IV-IV, on peut citer : SiC, SiGe ...

Les semi-conducteurs III-V sont des semi-conducteurs composites fabriqués à partir d'un ou plusieurs éléments de la colonne III du tableau périodique des éléments (par exemple : Al, Ga, In) et d'un ou plusieurs éléments de la colonne V du tableau périodique des éléments (par exemple : As, Sb, N, P). Comme exemples de semi-conducteurs III-V, on peut citer : GaAs, GaSb, GaN, AlN, InP ...

Les semi-conducteurs II-VI sont des semi-conducteurs composites fabriqués à partir d'un ou plusieurs éléments de la colonne II du tableau périodique des éléments (par exemple : Cd) et d'un ou plusieurs éléments du groupe des chalcogènes (colonne VI) du tableau périodique des éléments (par exemple : S, Se, Te). Comme exemples de semi-conducteurs II-VI, on peut citer : CdS, CdSe, CdTe.

Les semi-conducteurs III-V notamment sont des matériaux de choix pour les dispositifs optoélectroniques. La majorité des semi-conducteurs III-V ont une structure de bande directe, ce qui implique une meilleure émission et absorption des photons par rapport aux semi-conducteurs à gap indirects tels que le silicium (Si) et le germanium (Ge). Ainsi les dispositifs émetteurs de lumière tels que les LED et les lasers sont principalement basés sur les matériaux III-V. De la même manière, les dispositifs absorbant de la lumière tels que détecteurs, capteurs et composants photovoltaïques bénéficient des propriétés optoélectroniques des matériaux III-V. Par ailleurs, un grand nombre de matériaux III-V présentent des mobilités de porteurs (électrons, trous) élevées permettant la réalisation de transistors hautes performances pour la logique et la radiofréquence (RF).

Par « matériau 2D », on entend un matériau constitué d'un feuillet de quelques atomes d'épaisseurs, typiquement de 10 atomes maximum. Ces matériaux sont saturés électroniquement. L'empilement de plusieurs de ces feuillets se fait donc via des liaisons de van der Waals. Parmi les matériaux 2D, certains sont semi-conducteurs. Leur très faible épaisseur donne naissance à des propriétés électroniques et optoélectroniques tout à fait singulières.

L'hétéro-intégration monolithique de semi-conducteurs d'intérêt (IV-IV, III-V, II-VI, matériaux 2D...) par épitaxie sur substrat de silicium est une voie très prometteuse pour ajouter de nouvelles fonctionnalités (électroniques, optiques, mécaniques, capteurs, biologiques...) aux circuits intégrés CMOS (Complementary Metal Oxide Semiconductor) de technologie hautement mature basée sur le silicium, ouvrant ainsi un large champ d'applications et de fonctionnalités.

L'hétéro-intégration monolithique implique le dépôt direct par épitaxie de couches d'un matériau semi-conducteur (IV-IV, III-V, II-VI, matériau 2D...) sur un substrat de silicium.

Cependant, l'épitaxie sur substrat de silicium soulève de nombreuses difficultés, les principales étant :
- la différence de coefficient de dilatation thermique entre le silicium et le matériau semi-conducteur à épitaxier qui peut conduire à une déformation de la couche épitaxiée de semi-conducteur, ce qui peut engendrer une courbure du substrat voire la création de fissures dans la couche épitaxiée ;
- la différence de paramètre de maille entre le matériau semi-conducteur à épitaxier et le silicium qui induit des contraintes dans la couche épitaxiée, contraintes qui relaxent par création de défauts cristallins formant des dislocations à l'interface entre la couche épitaxiée et le silicium. Ces dislocations peuvent se propager dans la couche épitaxiée (dislocations émergeantes (ou « TD(s) » pour « Threading dislocations » en anglais) ;
- la différence de polarité entre le silicium et la couche épitaxiée peut conduire à la formation de défauts planaires, les parois d'antiphase.

Ces défauts cristallins générés à l'interface sont source de dégradation majeure des propriétés électroniques et optiques des matériaux épitaxiés.

Parmi ces défauts, les dislocations émergeantes sont actuellement les défauts dont il est le plus difficile de s'affranchir.

Plusieurs solutions sont proposées dans la littérature pour épitaxier une couche de matériau semi-conducteur de bonne qualité cristalline. Les solutions consistent en général à épitaxier sélectivement la couche de semi-conducteur dans un masque comprenant des motifs de diélectrique (généralement en SiO₂) préalablement structurés sur le substrat de silicium. Ces solutions portent la dénomination générique de « Selective Area Epitaxy » (SAE) ou « Selective Area Growth » (SAG). Le dépôt de la couche de semi-conducteur est généralement réalisé par MOCVD. Les solutions SAE offrent plusieurs avantages :
- la croissance ne se produit que dans les zones ouvertes (désignées par « tranchées ») entre les motifs (débouchant sur la surface de Si) ; le matériau semi-conducteur peut donc être déposé uniquement dans les zones d'intérêt, ce qui est très important pour la co-intégration avec des dispositifs à base de Si ;
- le dépôt de matériaux dans des ouvertures très confinées conduit à une réduction des dislocations qui sont piégées par les parois des motifs du masque ;
- la courbure du substrat et l'apparition de fissures dans la couche, causés par les différents coefficients de dilatation thermique, peuvent être atténuées.

Plusieurs variantes de ces solutions sont présentées dans la publication « How to control defect formation in monolithic III/V hetero-epitaxy on (100) Si? A critical review on current approaches ; Kunert B et al. 2018 Semicond. Sci. Technol. 33 093002 *».*

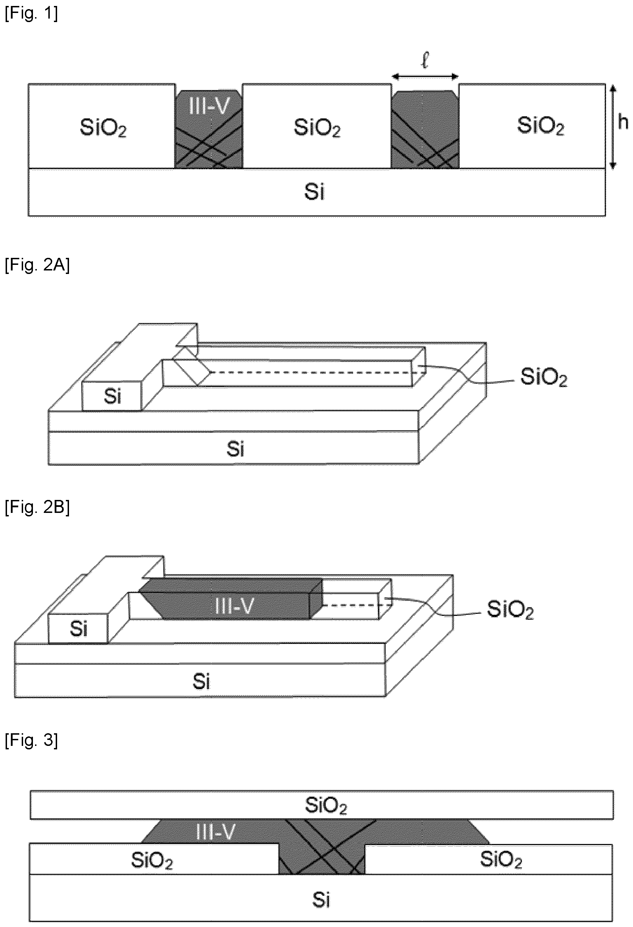

Une première variante consiste à faire croitre les matériaux dans des tranchées de diélectrique. Elle est connue sous l'acronyme d'« ART » pour « Aspect Ratio Trapping » en anglais, illustrée en figure 1. Elle consiste à piéger les dislocations émergentes de la couche du semi-conducteur III-V contre les parois du masque diélectrique (SiO₂) si le rapport d'aspect (AR), correspondant à la hauteur (h) du masque divisée par la largeur (1) de la tranchée est suffisant. La mise en œuvre de cette première variante est assez simple mais sa principale limite est que les dislocations émergeantes parallèles aux tranchées ne sont pas piégées par les parois. Ainsi, la densité de dislocations émergeantes reste élevée avec comme meilleurs résultats des valeurs saturant autour de 10⁷ cm⁻².

Le brevet FR3010828 par exemple a pour objet un procédé de fabrication de motifs de matériau semi-conducteur III-V sur un substrat semi-conducteur à base de silicium ou de germanium comprenant : une étape de réalisation d'un masque de croissance à la surface du substrat et une étape de croissance de motifs de matériau III-V entre les motifs de masquage. Pour cette étape de croissance, des paramètres optimisés sont déterminés de manière à faire croître des matériaux III-V avec des dislocations émergentes piégées et ainsi élaborer des couches de bonne qualité cristalline présentant une faible densité de dislocations.

Une deuxième variante est connue sous le nom de croissance dans des tubes de diélectrique, également désignée par « TASE » pour « Template Assisted Selective Epitaxy » en anglais, illustrée en figures 2A et 2B.

Une troisième variante, d'un principe proche du TASE, est connue sous le nom de croissance épitaxiale latérale confinée, également désignée par « CELO » pour « Confined Epitaxial Lateral Overgrowth » en anglais, illustrée en figure 3. Elle consiste à tout d'abord faire croitre le matériau dans des tranchées (de la même manière que pour l'ART) puis à ensuite forcer la couche à croitre latéralement grâce à un deuxième confinement, en hauteur cette fois, qui va encapsuler la couche. On va donc ajouter de l'ART horizontale à l'ART verticale. Ce deuxième confinement va permettre de piéger les TDs résiduelles n'ayant pas été bloquées par les parois des tranchées.

Si les deuxième et troisième variantes permettent de piéger d'avantage (voire la très grande majorité) de dislocations émergeantes et donc de réduire la densité de dislocations émergeantes, elles présentent néanmoins des inconvénients :
- le procédé technologique de structuration du substrat est très lourd à mettre en œuvre, avec notamment un grand nombre d'étapes à réaliser ;
- comme la surface de contact entre le matériau épitaxié et le diélectrique est très grande, le diélectrique doit être de très bonne qualité pour éviter les défauts ;
- l'épitaxie dans des tubes de diélectrique est difficile à contrôler, en particulier pour des alliages ternaires et quaternaires pour lesquels une fluctuation de la composition des alliages est constatée.

L'invention vise à disposer d'un procédé d'hétéro-intégration monolithique de semi-conducteurs d'intérêt (IV-IV, III-V, II-VI, matériaux 2D...) par épitaxie sélective sur substrat de silicium sans les inconvénients précités de l'art antérieur.

Plus particulièrement elle vise à disposer d'un procédé d'hétéro-intégration monolithique de semi-conducteurs d'intérêt (IV-IV, III-V, II-VI, matériaux 2D...) par épitaxie sélective sur substrat de silicium qui permette de réduire les défauts générés à l'interface entre le silicium et la couche épitaxiée, en particulier les dislocations, et qui soit relativement simple à mettre en œuvre.

### Expose de l'invention

Un premier objet de l'invention permettant de remédier à ces inconvénients est un procédé d'hétéro-intégration d'un matériau semi-conducteur d'intérêt sur un substrat de silicium caractérisé en ce qu'il comprend :
- une étape de structuration du substrat qui comprend une étape de réalisation d'un masque de croissance à la surface du substrat de silicium, ledit masque de croissance comprenant une pluralité de motifs de masquage, deux motifs de masquage étant séparés par une tranchée dans laquelle le substrat de silicium est découvert ;
- une étape de formation d'une couche tampon bidimensionnelle en un matériau 2D, ladite couche tampon étant exempte de liaisons pendantes sur sa surface libre et étant formée sélectivement sur un plan de silicium d'orientation [111] dans au moins une tranchée, ladite étape de formation d'une couche tampon étant réalisée après l'étape de structuration et étant réalisée par la technique de dépôt en phase vapeur aux organométalliques (MOCVD) ;
- une étape de formation d'au moins une couche d'un matériau semi-conducteur d'intérêt sur la couche tampon.

Le matériau semi-conducteur d'intérêt est de préférence un matériau semi-conducteur IV-IV, III-V, II-VI et/ou un matériau semi-conducteur 2D.

Selon un mode de réalisation, la couche tampon est formée sélectivement sur un plan de silicium d'orientation [111] dans chaque tranchée.

Selon l'invention, les termes « sélectif » ou « sélectivement », comme la croissance sélective ou la passivation sélective, sont définis au sens de la SAG, à savoir dans des tranchées d'un masque de croissance.

Selon l'invention, un « matériau 2D » désigne un matériau constitué d'un feuillet de quelques atomes d'épaisseurs, typiquement de 10 atomes maximum, avec des liaisons fortes entre les atomes dans le plan du feuillet, et des liaisons faibles de type van der Waals en dehors du plan du feuillet. On peut également parler de « matériau bidimensionnel », ou encore de « matériau lamellaire ». De même, une « couche bidimensionnelle » désigne une couche réalisée avec un matériau 2D donc un matériau constitué d'un feuillet d'atomes présentant des liaisons fortes dans le plan du feuillet, et des liaisons faibles de van der Waals en dehors du plan du feuillet, par exemple entre deux feuillets ou sur une surface libre de feuillet. Un matériau, qui n'est pas structuré en feuillet(s) mais avec des liaisons ioniques ou covalentes dans tout son volume peut aussi être désigné par « matériau 3D », par exemple un matériau semi-conducteur traditionnel.

L'invention est un procédé permettant de faire croitre sélectivement, par MOCVD, une couche tampon bidimensionnelle, sans liaisons covalentes ou pendantes, dans des tranchées d'un masque de croissance, de préférence en diélectrique, sur un substrat de silicium, pouvant être un substrat de silicium Si(001) (également désigné par Si(100)) standard ou un substrat de silicium Si(111).

La couche tampon bidimensionnelle est réalisée en un matériau bidimensionnel, avec des conditions opératoires adaptées. Elle peut fonctionner alors comme un substrat universel pour la croissance localisée de tout type de semi-conducteur d'intérêt avec une défectivité réduite (notamment une densité de dislocations émergeantes réduite) et donc présentant des propriétés physico-chimiques optimisées. En effet, contrairement à une croissance directe sur un substrat de silicium, la croissance sur la couche tampon bidimensionnelle permet de s'affranchir de la différence de paramètres de maille. Elle se fait sans, ou avec très peu, de liaisons covalentes ou pendantes à l'interface. La formation de cette couche tampon bidimensionnelle est en effet réalisée en favorisant une croissance épitaxiale de van der Waals, permettant ainsi la formation d'un matériau non contraint, ce qui évite le processus de relaxation par génération de dislocations émergeantes. Ceci permet ainsi de former une couche d'un matériau semi-conducteur d'intérêt qui est un matériau cristallin présentant une densité de dislocations émergentes inférieure à 10⁶/cm².

Parmi les avantages du procédé de l'invention, on peut citer :
- l'obtention d'une couche semi-conductrice par hétéro-épitaxie sur substrat standard de silicium, tel que le Si(100) 300mm utilisé par l'industrie de la microélectronique, présentant une faible densité de défauts cristallins ;
- la simplicité et le faible coût d'un procédé nécessitant très peu d'étapes et pouvant être mis en œuvre avec les moyens standards ;
- l'universalité de la technique : la croissance de tous types de semi-conducteurs et d'hétéro-structures est envisageable (IV-IV, III-V, II-VI, hétéro-structures de matériaux 2D...), quelle que soit la différence de paramètre de maille ou de structure cristalline avec le silicium.

En outre, la croissance d'un matériau semi-conducteur 3D (GaAs, GaN,...) sur un matériau 2D est généralement très difficile sur un substrat de silicium non structuré en motifs de masquage diélectrique, en raison de la faible nucléation des adatomes arrivant en surface (du fait de l'absence de liaisons pendantes du matériau 2D). On désigne par « adatome » un atome adsorbé sur la surface du substrat. Il en résulte une croissance en ilots éparses sur la surface. Le procédé selon l'invention qui est une croissance sélective dans des tranchées du masque de croissance permet de concentrer la nucléation sur un nombre très limité de zones du substrat : la densité de nucléation s'en trouve considérablement renforcée et permet notamment la croissance d'une couche continue d'un matériau 3D sur un matériau 2D.

La densité de dislocations émergentes très faible permet ainsi la co-intégration de composants électroniques, optoélectroniques, capteurs, imageurs performants et de manière générale tous les composants « More than Moore » sur substrat silicium d'orientation [001], voire d'orientation [111], notamment compatible avec la technologie CMOS.

De préférence, les motifs de masquage sont en un matériau diélectrique.

Selon un mode de réalisation, le substrat de silicium est un substrat de silicium d'orientation [001]. Dans ce cas, l'étape de structuration comprend en outre une étape de formation d'une facette de silicium d'orientation [111] dans le substrat de silicium, de manière à former au moins un plan de silicium d'orientation [111]. Chaque facette est réalisée via une tranchée, c'est-à-dire dans le substrat de silicium qui est découvert au fond de la tranchée.

Une facette peut présenter une surface inclinée d'un angle inférieur à 90° par rapport à la surface du substrat de silicium dans laquelle ladite facette est formée.

Selon un mode de réalisation particulier, deux facettes de silicium d'orientation [111] sont formées dans une tranchée, chaque facette présentant une surface inclinée d'un angle inférieur à 90° par rapport à la surface du substrat de silicium dans laquelle ladite facette est formée. Deux facettes peuvent ainsi notamment former un V dont le premier segment forme un angle de +54,7° par rapport à la surface du substrat et le second segment forme un angle de -54,7° par rapport à la surface du substrat

L'étape de formation d'une facette peut comprendre une étape de gravure chimique du substrat de silicium, par exemple une gravure chimique à base d'hydroxyde de tétraméthylammonium, d'hydroxyde de tétraéthylammonium, d'ammoniaque, d'hydroxyde de potassium ou d'hydroxyde de sodium.

Selon un mode de réalisation, le substrat de silicium est un substrat de silicium d'orientation [111], la surface dudit substrat formant le plan de silicium d'orientation [111].

Selon un mode de réalisation, le procédé comprend en outre une étape de passivation consistant en un dépôt d'un biplan atomique de gallium et de sélénium sur le plan de silicium d'orientation [111] de manière à former une surface passivée en silicium-gallium-sélénium sur ledit plan de silicium. La surface passivée peut également être désignée « couche de passivation ».

Selon un mode de réalisation particulier, l'étape de passivation est réalisée entre l'étape de structuration et l'étape de formation de la couche tampon.

L'étape de passivation peut comprendre une étape de dépôt en phase vapeur avec des précurseurs organométalliques (MOCVD).

Les précurseurs organométalliques peuvent être le TriMéthylGallium (TMGa) et le Di-isoPropylSelenium (DiPSe).

Selon un mode de réalisation, l'étape de formation d'au moins une couche tampon consiste en une épitaxie de van der Waals et comprend :
- une première étape de nucléation d'un matériau 2D sur la surface passivée; et
- une première étape de croissance des nuclei obtenus à l'issue de la première étape de nucléation.

La première étape de nucléation peut comprendre une étape de dépôt en phase vapeur avec des précurseurs organométalliques (MOCVD).

Les précurseurs organométalliques peuvent être le TriMéthylGallium (TMGa) et le Di-isoPropylSelenium (DiPSe).

Selon un mode de réalisation, l'étape de réalisation d'au moins une couche d'un matériau semi-conducteur d'intérêt consiste en une étape d'épitaxie supplémentaire comprenant :
- une seconde étape de nucléation du semi-conducteur d'intérêt sur la couche tampon ; et
- une seconde étape de croissance de la couche de nucléation obtenue à l'issue de la seconde étape de nucléation.

La seconde étape de nucléation peut comprendre une étape de dépôt en phase vapeur avec des précurseurs organométalliques (MOCVD).

Selon un mode de réalisation, le procédé comprend en outre une moins une étape de retrait de l'oxyde natif, par exemple par attaque chimique à l'acide fluorhydrique, préalablement à l'étape de formation de la couche tampon ou à l'étape de passivation.

La largeur d'une tranchée est généralement inférieure ou égale à 20 micromètres et est de préférence inférieure ou égale à 2 micromètres.

Le matériau 2D de la couche tampon peut être choisi parmi le GaSe, le GaS, le GaTe, le MoS₂, le MoSe₂, le WS₂, le WSe₂, le InSe ou une combinaison desdits matériaux.

Le matériau semi-conducteur d'intérêt peut être choisi parmi le GaAs, GaSb, GaN, AlN.

Un second objet de l'invention est une structure obtenue par le procédé d'hétéro-intégration selon la premier objet de l'invention, ladite structure comprenant :
- un substrat de silicium ;
- une pluralité de motifs de masquage disposés sur le substrat de silicium, deux motifs de masquage étant séparés par une tranchée ;
- une couche tampon bidimensionnelle disposée dans chaque tranchée ;
- une couche d'un matériau semi-conducteur d'intérêt disposée sur la couche tampon bidimensionnelle et au moins dans chaque tranchée, ladite couche d'un matériau semi-conducteur d'intérêt présentant une densité de dislocations émergentes inférieure à 10⁶/cm².

De préférence, le matériau semi-conducteur d'intérêt est un matériau semi-conducteur IV-IV, III-V, II-VI et/ou un matériau semi-conducteur 2D.

De préférence, les motifs de masquage sont en un matériau diélectrique.

Avantageusement, la structure comprend en outre une couche de passivation en silicium-gallium-sélénium entre le substrat de silicium et la couche tampon bidimensionnelle.

### Brève description des figures

D'autres caractéristiques et avantages de l'invention apparaîtront à l'aide de la description qui suit, donnée à titre illustratif et non limitatif, faite en regard des figures annexées parmi lesquelles
[Fig.1] représente une première variante de croissance épitaxiale sélective selon l'état de la technique ;
[Fig.2A] et
   [Fig.2B] représentent une deuxième variante de croissance épitaxiale sélective selon l'état de la technique ;
[Fig.3] représente une troisième variante de croissance épitaxiale sélective selon l'état de la technique ;
[Fig.4A],
   [Fig.4B],
   [Fig.4C],
   [Fig.4D],
   [Fig.4E],
   [Fig.4F],
   [Fig.4G],
   [Fig.4H],
   [Fig.4I],
   [Fig.4J],
   [Fig.4K],
   [Fig.4L],
   [Fig.4M],

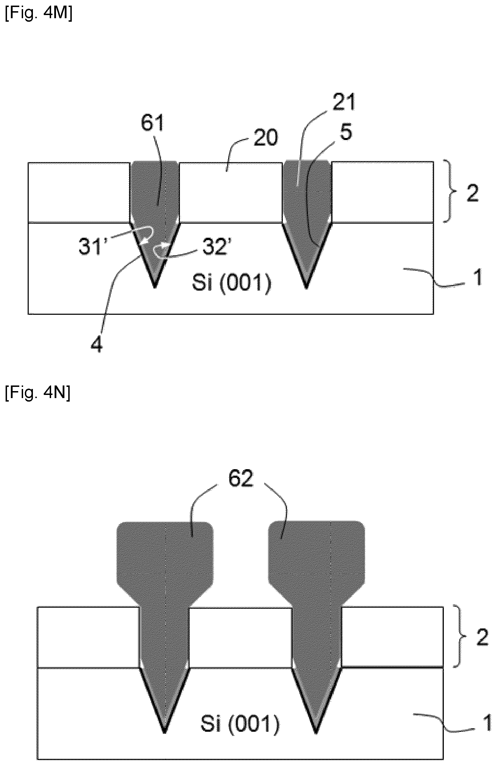

   [Fig.4N] représentent un exemple et des variantes de procédé d'hétéro-intégration selon l'invention.

### Description détaillée de l'invention

Les figures 1, 2A, 2B et 3 (état de la technique) ont été décrites précédemment et ne seront pas reprises ici.

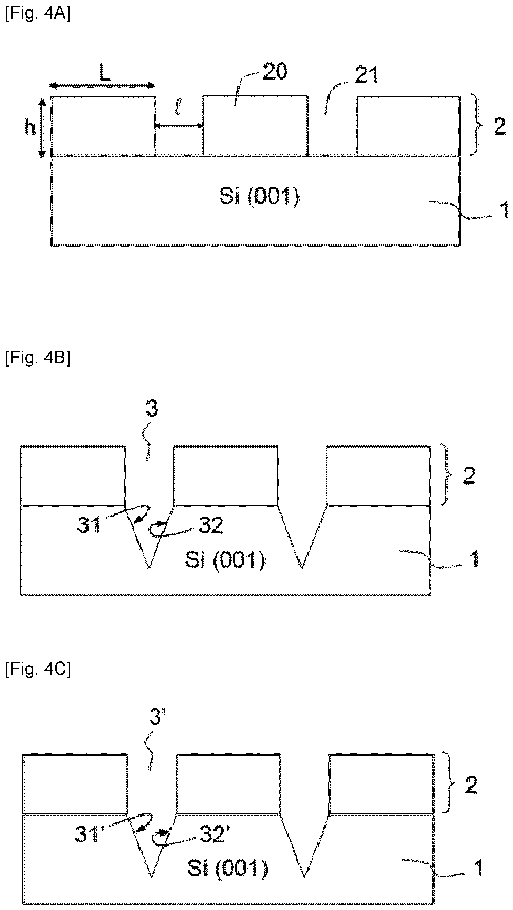

Les figures 4A à 4N représentent un exemple, avec des variantes, de procédé d'hétéro-intégration selon l'invention. Dans cet exemple, on part d'un substrat 1 de silicium qui présente une orientation cristalline [001] et que l'on pourra donc désigner par Si(001).

Le procédé comprend une étape de structuration du substrat de silicium orienté [001] qui comprend une étape de réalisation d'un masque de croissance 2 à la surface dudit substrat (figure 4A). Le masque de croissance 2 comprend des motifs 20 de masquage. Le masque de croissance est de préférence réalisé en un matériau diélectrique, généralement du SiO₂ ou du SiN, présentant une sélectivité à la gravure par rapport au substrat silicium. Deux motifs de masquage consécutifs (ou adjacents) sont séparés l'un de l'autre par une distance 1. Cette distance 1 correspond selon cet exemple à la largeur d'une tranchée 21. Une tranchée correspond à une zone non masquée du substrat 1 par le matériau diélectrique (ou « zone découverte »).

Les motifs du masque peuvent être réalisés en partant d'un substrat de silicium, en procédant à une opération d'oxydation thermique dudit substrat, permettant de déposer une couche supérieure d'oxyde de silicium (couche de SiO₂), puis en définissant des tranchées par lithographie et gravure dans la couche de SiO₂ afin de découvrir la surface de silicium au fond de chaque tranchée.

A ce stade du procédé, les tranchées ont une profondeur h et une largeur 1 (distance entre deux motifs). La largeur 1 d'une tranchée peut être comprise entre quelques dizaines de nanomètres et 20 micromètres. De préférence, la largeur 1 d'une tranchée est inférieure à 2 micromètres. La longueur L des motifs de masquage peut être supérieure à plusieurs dizaines de micromètres.

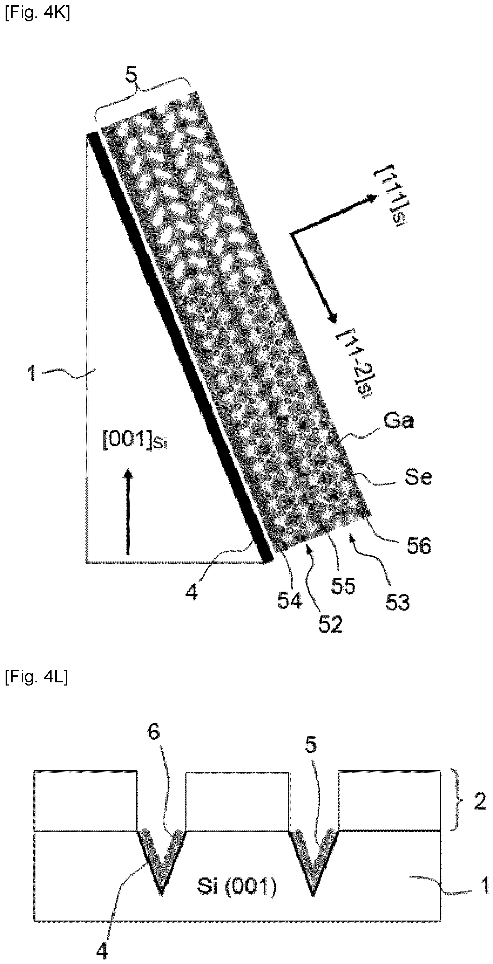

Selon l'exemple représenté en figure 4B, l'étape de structuration comprend une étape de gravure chimique du substrat de silicium 1 dans chaque tranchée 21 de manière à former des facettes 31, 32 de silicium présentant une orientation [111] que l'on pourra désigner par Si(111). Les facettes de Si(111) forment des rainures en V dans le substrat de silicium 1.

La gravure chimique peut être anisotrope et réalisée avec des solutions à base d'hydroxyde de tétraméthylammonium ou de tétraéthylammonium dilué dans l'eau, avec de l'ammoniaque, de l'hydroxyde de potassium ou de l'hydroxyde de sodium. Les températures des solutions lors de l'étape de gravure varient classiquement entre 20°C et 100°C.

Préalablement à la gravure chimique, une première étape de retrait de l'oxyde natif (non représentée) peut être nécessaire, notamment selon les solutions de gravure chimique mises en œuvre. Cette première étape de retrait de l'oxyde natif est généralement réalisée par attaque chimique à l'acide fluorhydrique (HF) ; typiquement en exposant le substrat à une solution d'acide fluorhydrique dilué (par exemple entre 0,2 à 1% en concentration volumique) durant 30 à 90 secondes.

Après l'étape de gravure chimique, l'étape de structuration comprend une seconde étape de retrait de l'oxyde natif du silicium de manière à obtenir des facettes désoxydées 31', 32' de Si(111), comme représenté en figure 4C. Cette seconde étape de retrait de l'oxyde natif est généralement réalisée par attaque chimique à l'acide fluorhydrique (HF), typiquement à l'aide d'une solution d'acide fluorhydrique dilué (par exemple à 0,5% en concentration volumique) durant 30 à 60 secondes.

L'étape de gravure chimique pour former les plans de Si(111) n'est pas nécessaire si l'on utilise un substrat de silicium orienté [111] à la place du substrat Si(001).

L'étape de gravure chimique n'est notamment pas nécessaire si on dispose d'un substrat de silicium qui dispose déjà d'au moins un plan en silicium d'orientation [111] : cela peut signifier que la surface du substrat est en Si(111), ou que le substrat en Si(001) comprend déjà des facettes de Si(111).

Dans le cas d'un substrat en Si(111), on peut concevoir le masque de croissance sur ledit substrat de silicium de manière à ce que les motifs de masquage laissent des parties du substrat Si(111) découvertes. Ensuite, on peut procéder aux étapes décrites ci-après.

Plus généralement, quelle que soit l'orientation du substrat de silicium, les motifs de masquage doivent laisser découverts des plans de silicium orientés [111].

Dans le cas d'un substrat Si(001), les plans orientés [111] formeront typiquement un V dont le premier segment forme un angle de +54,74° par rapport au substrat et le second segment forme un angle de -54,74° par rapport au substrat.

Dans le cas d'un substrat Si(111), les plans découverts de Si(111) seront sensiblement à 0° par rapport à la surface du substrat.

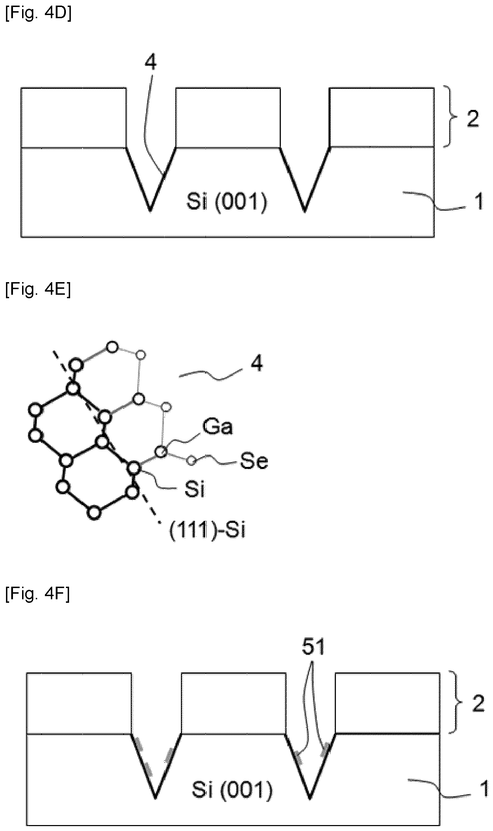

Le procédé comprend ensuite une étape de passivation sélective des facettes de Si(111), consistant à déposer sur lesdites facettes un plan atomique de gallium suivi d'un plan atomique de sélénium (figure 4D). Cela permet d'obtenir la formation d'une surface de silicium passivée (également désignée par « couche de passivation » 4) en Si-Ga-Se, telle qu'illustrée en figure 4E. Cette surface est saturée électroniquement et est stable à haute température (jusqu'à environ 650-700°C). Cette couche de passivation 4 permet de faire ensuite croître un matériau 2D par épitaxie de van der Waals, comme décrit plus après.

Un plan atomique de Ga ainsi lié à un plan atomique de Se, peut être nommé « biplan atomique » et peut être vu comme un demi-feuillet du matériau « GaSe 2D ». En effet, le GaSe 2D désigne le séléniure de gallium bidimensionnel (en feuillet) constitué de quatre plans atomiques de séquence Se-Ga-Ga-Se.

Par « surface passivée électroniquement », ou « couche de passivation », ou encore « surface saturée électroniquement », on entend une surface sans liaison pendante : les atomes de gallium et de sélénium composant la couche de passivation ont tous leurs électrons de valence appariés.

Pour réaliser cette étape de passivation, le substrat de silicium est typiquement introduit dans une chambre de croissance et le biplan atomique GaSe est déposé par la technique de dépôt en phase vapeur aux organométalliques dite « MOCVD » (pour « Metal Organic Chemical Vapour Déposition » en anglais). La technique MOCVD est effectuée par transport de précurseurs de Ga et de Se qui sont introduits vers la chambre de croissance via un gaz vecteur, et ce, de manière à venir former la couche de passivation sur les facettes de Si(111) qui sont dans les tranchées du masque de croissance (donc découvertes).

Pour obtenir la couche de passivation Si-Ga-Se en MOCVD, on utilise des précurseurs organométalliques introduits simultanément dans la chambre, qui sont typiquement le TriMéthylGallium (TMGa) et le Di-isoPropylSelenium (DiPSe) qui sont gazeux à la température d'utilisation dans le procédé. Alternativement, il peut s'agir de tout autre précurseur de gallium et/ou de tout autre précurseur de sélénium.

Le gaz vecteur est typiquement de l'hydrogène. Alternativement, il peut s'agir de l'azote, de l'argon, ou encore tout autre gaz inerte de la colonne VIII du tableau périodique.

L'étape de passivation est généralement réalisée entre 400°C et 650°C.

La pression totale est adaptée en fonction de la géométrie de la chambre, mais des valeurs typiques sont comprises entre 5 et 200 Torr.

La pression partielle du précurseur gallium est généralement comprise entre 1 et 200 mTorr.

Le rapport de flux molaire III/VI (précurseur groupe III/précurseur groupe VI) est généralement compris entre 1 et 10.

Selon un exemple de réalisation particulier, les conditions de l'étape de passivation sont :
- pression totale dans la chambre : 10-20 Torr ;
- pression partielle de TMGa : environ 10 mTorr ;
- rapport flux molaire Se/Ga (VI/III) : environ 3-4 ;
- température : 530-550°C ;
- temps de croissance t : entre 2 et 5 secondes.

La technique MOCVD est avantageuse car elle permet une bonne reproductibilité et des fortes vitesses de croissance cristalline. En outre, elle est d'application industrielle.

Alternativement, on peut utiliser d'autres techniques de dépôt en phase vapeur dite « CVD » (pour « Chemical Vapour Déposition » en anglais) telle que le dépôt de couches minces atomiques (ALD pour « Atomic Layer Déposition » en anglais).

Comme cela a été évoqué précédemment, à la suite de l'étape de passivation, le procédé comprend une étape d'épitaxie, de type épitaxie de van der Waals, consistant à épitaxier un matériau 2D sur la couche de passivation 4 de manière à former une couche tampon 5 bidimensionnelle, visible en figure 4K. Cette étape d'épitaxie comprend typiquement une première étape de nucléation et une première étape de croissance ou étape de croissance latérale des nuclei. Ces étapes sont détaillées ci-après.

Par « croissance latérale », on entend que chaque nuclei croit en s'étendant principalement selon le plan de la couche de passivation et plus généralement selon le plan sur lequel il a été déposé.

Selon l'exemple représenté, la couche tampon 5 est réalisée en séléniure de gallium structuré en feuillet(s) (GaSe 2D). En d'autres termes, la couche tampon 5 comprend au moins un feuillet de GaSe 2D.

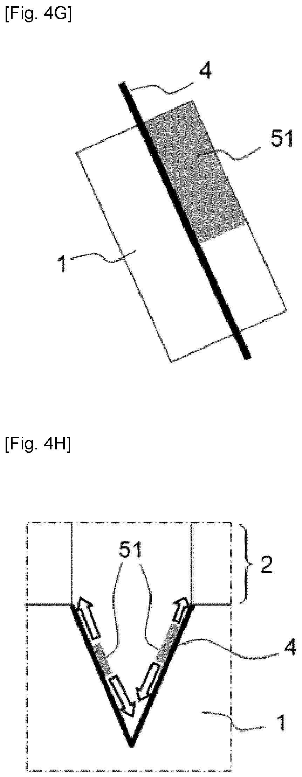

La première étape de nucléation est une étape de nucléation de GaSe. L'étape de nucléation du GaSe est réalisée par le dépôt de grains 51 de GaSe sur la couche de passivation 4, visible en figures 4F et 4G. Les nuclei de GaSe présentent une largeur initiale égale à quelques dizaines de nanomètres.

Pour réaliser la nucléation, le substrat est maintenu dans la chambre de croissance et la technique MOCVD est utilisée. Les précurseurs pouvant être utilisés sont les mêmes que pour l'étape de passivation. Les pressions partielles de précurseur mises en œuvre sont inférieures à celles de l'étape de passivation.

Le gaz vecteur est typiquement de l'hydrogène. Alternativement, il peut s'agir de l'azote, de l'argon, ou encore tout autre gaz inerte de la colonne VIII du tableau périodique.

La première étape de nucléation est généralement réalisée entre 400°C et 650°C.

La pression totale dans la chambre a des valeurs typiquement comprises entre 5 et 80 Torr.

La pression partielle du précurseur Ga est généralement comprise entre 1 et 50 mTorr.

Le rapport de flux molaire VI/III dépend du type de précurseur. Des valeurs typiques sont comprises entre 3 et 4.

Selon un exemple de réalisation particulier, les conditions de la première étape de nucléation sont les suivantes :
- pression totale dans la chambre : 5-20 Torr ;
- pression partielle de TMGa: environ 2-3 mTorr ;
- rapport flux molaire Se/Ga (VI/III) : environ 3-4 ;
- température : 530-550°C.

L'épaisseur des nuclei atteint environ 8 Å pour un temps de croissance t₁ compris entre 2 et 3 secondes.

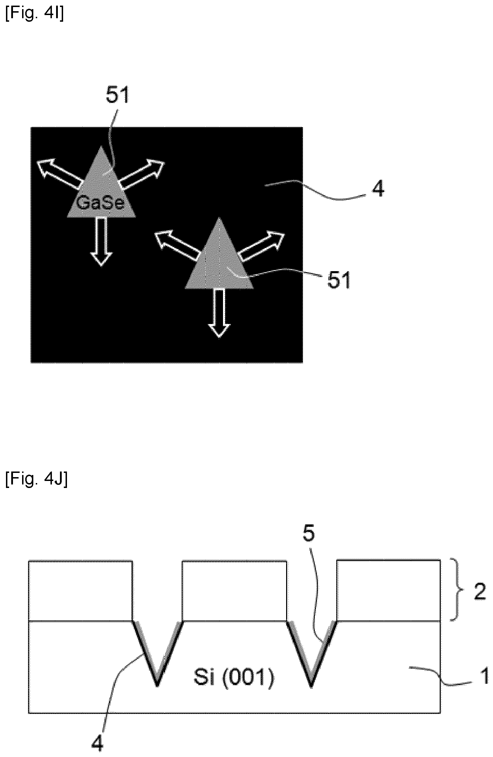

Après nucléation on fait croitre latéralement, sur plusieurs micromètres, les nuclei de GaSe, comme cela est représenté en figures 4H et 4I, jusqu'à obtenir au moins un feuillet continu sur les facettes orientée [111] 52. Chaque feuillet de GaSe 2D est orienté cristallographiquement par rapport à la surface de Si(111), comme illustré en figures 4J et 4K.

La figure 4K représente une couche tampon 5 formée par deux feuillets de GaSe disposées sur la couche de passivation 4 : un feuillet inférieur 52 et un feuillet supérieur 53. La liaison 54 entre le feuillet inférieur 52 et la couche de passivation 4 et la liaison 55 entre les deux feuillets 52, 53 sont des liaisons faibles de van der Waals. La surface extérieure 56 du feuillet supérieur 53 n'a pas de liaisons pendantes.

Cette première étape de croissance, ou croissance latérale des grains de GaSe est réalisée à plus faible pression partielle et plus haute température que la première étape de nucléation.

Le substrat est maintenu dans la chambre de croissance.

La première étape de croissance, ou croissance latérale, est généralement réalisée entre 570°C et 650°C.

La pression totale dans la chambre a des valeurs typiquement comprises entre 5 et 80 Torr.

La pression partielle du précurseur Ga est généralement comprise entre 0,5 et 5 mTorr.

Le rapport de flux molaire VI/III dépend du type de précurseur. Des valeurs typiques sont comprises entre 3 et 4.

Selon un exemple de réalisation particulier, les conditions de la première étape de croissance sont les suivantes :
- pression totale dans la chambre : 5-20 Torr,
- pression partielle de TMGa : environ 1 mTorr ;
- rapport flux molaire Se/Ga (VI/III) : environ 3-4 ;
- température : 600-640°C.

Le temps de croissance t₂ pour faire complètement coalescer des grains de GaSe en un feuillet continu est d'environ 200 secondes.

Pour obtenir un feuillet continu de GaSe 2D (épaisseur de l'ordre de 8 Å), il faut nécessairement un temps t₁ de nucléation et un temps t₂ de croissance latérale. Comme t₂ est très supérieur à t₁ on peut négliger t₁ de sorte que pour un feuillet, il faut environ 200 secondes, et par extension ;
- pour deux feuillets, il faut environ 400 secondes ;
- pour trois feuillets, il faut environ 600 secondes.

La vitesse de croissance est donc de l'ordre de 2-3 Å.min⁻¹.

La couche tampon est formée par un (ou plusieurs) feuillet(s) du matériau 2D. Dans l'exemple représenté, la couche tampon 5 est formée par deux feuillets 52 et 53 de GaSe 2D.

La couche tampon en GaSe est stable jusqu'à environ 950°C. Elle est exempte de liaisons pendantes. Elle est donc adaptée pour la croissance sans contrainte mécanique de matériaux semi-conducteurs d'intérêt (IV-IV, III-V, II-VI, matériaux 2D...) par épitaxie, comme le GaAs dans l'exemple représenté.

Selon le type de matériau semi-conducteur d'intérêt à épitaxier, la couche tampon bidimensionnelle en GaSe peut être remplacée par une couche tampon bidimensionnelle en un matériau 2D autre que le GaSe, à condition de conserver l'étape de passivation du Si(111) par un plan atomique de gallium Ga suivi d'un plan atomique de sélénium Se. En exemple, on peut citer un des matériaux suivants : GaS, GaTe, MoS₂, MoSe₂, WS₂, WSe₂, InSe. On peut combiner plusieurs couches différentes parmi une combinaison des matériaux cités précédemment. De préférence, le matériau 2D est un matériau stable jusqu'à 1000°C.

Le procédé comprend ensuite une étape supplémentaire d'épitaxie consistant à épitaxier un matériau semi-conducteur d'intérêt, qui est typiquement un matériau semi-conducteur IV-IV, III-V, II-VI ou un matériau semi-conducteur 2D, sur la couche tampon bidimensionnelle. Cette étape supplémentaire d'épitaxie comprend typiquement une seconde étape de nucléation et une seconde étape de croissance, qui est une croissance rapide à haute température. Ces étapes sont détaillées ci-après.

Dans l'exemple représenté, le matériau semi-conducteur d'intérêt est de l'Arséniure de gallium (GaAs). Ainsi, la seconde étape de nucléation est une étape de nucléation de GaAs. Mais l'exemple n'est en rien limitatif et le procédé est le même pour un autre matériau semi-conducteur parmi les matériaux semi-conducteurs IV-IV, III-V, II-VI ou les matériaux semi-conducteurs 2D ... Un matériau semi-conducteur d'intérêt peut être choisi parmi les matériaux suivants : GaAs, GaSb, GaN, AlN, ou une combinaison desdits matériaux.

L'étape de nucléation du GaAs, représentée en figure 4L, est réalisée par un dépôt sélectif sur la couche tampon 5 d'une couche de nucléation 6 en Arseniure de Gallium (GaAs).

Le substrat est maintenu dans la chambre de croissance et la technique MOCVD est utilisée.

Pour obtenir du GaAs en MOCVD, on utilise des précurseurs organométalliques, qui sont typiquement le TriMéthylGallium (TMGa) et le TertiaryButylArsine (TBAs), gazeux à la température d'utilisation dans le procédé. Alternativement, il peut s'agir de tout autre précurseur de gallium et/ou de tout autre précurseur d'arsenic.

Le gaz vecteur est typiquement de l'hydrogène. Alternativement, il peut s'agir de l'azote, ou de l'hélium, ou encore de tout autre gaz inerte de la colonne VIII du tableau périodique.

La seconde étape de nucléation est généralement réalisée entre 350°C et 450°C.

La pression totale dans la chambre a des valeurs typiques sont comprises entre 80 et 600 Torr.

La pression partielle du précurseur gallium est généralement comprise entre 0,5 et 5 Torr.

Le rapport de flux molaire est généralement compris entre 1,5 et 10.

Selon un exemple de réalisation particulier, les conditions de la seconde étape de nucléation sont :
- pression totale dans la chambre : 200-450 Torr ;
- durée : 200-400 secondes ;
- pression partielle de TMGa : environ 1,5 Torr ;
- rapport flux molaire As/Ga : environ 2,5 ;
- température : 370-390°C.

La seconde étape de croissance, représentée en figure 4M ou en figure 4N, se fait verticalement dans la tranchée. Le substrat est maintenu dans la chambre de croissance.

La température est augmentée pour faire coalescer les nuclei de GaAs et démarrer l'étape de croissance rapide du GaAs à haute température et basse pression, ce qui permet d'obtenir une couche localisée de GaAs d'excellente qualité cristalline.

La seconde étape de croissance est généralement réalisée entre 550°C et 670°C.

La pression totale dans la chambre a des valeurs typiques comprises entre 5 et 80 Torr.

La pression partielle du précurseur gallium est généralement comprise entre 10 et 50 mTorr.

Le rapport de flux molaire est généralement compris entre 2,5 et 15.

Selon un exemple de réalisation particulier, les conditions de la seconde étape de croissance sont :
- pression totale dans la chambre : 20 Torr ;
- durée : 300 secondes ;
- pression partielle de TMGa: environ 30 mTorr ;
- rapport flux molaire As/Ga : environ 3,5 ;
- température : 570-630°C.

On obtient ainsi une structure comprenant :
- un substrat 1 de silicium ;
- une pluralité de motifs de masquage 20 disposés sur le substrat de silicium 1, deux motifs de masquage étant séparés par une tranchée 21 ;
- une couche de passivation 4 disposée dans chaque tranchée ;
- une couche tampon bidimensionnelle 5 disposée sur la couche de passivation 4 dans chaque tranchée ;
- une couche 61, 62 d'un matériau semi-conducteur d'intérêt disposée sur la couche tampon bidimensionnelle 5 et remplissant au moins chaque tranchée, ladite couche d'un matériau semi-conducteur d'intérêt présentant une densité de dislocations émergentes inférieure à 10⁶/cm².

De préférence, le matériau semi-conducteur d'intérêt est un matériau semi-conducteur IV-IV, III-V, II-VI et/ou un matériau semi-conducteur 2D.

De préférence, les motifs de masquage sont en un matériau diélectrique.

En outre, la couche 61 de matériau semi-conducteur d'intérêt peut être confinée dans les tranchées, comme illustré en figure 4M. Alternativement, la couche 62 de matériau semi-conducteur d'intérêt peut être élargie par croissance latérale en dehors de chaque tranchée, par exemple pour former un nanofil horizontal de section carrée, comme illustré en figure 4N.

En outre, la couche de matériau semi-conducteur d'intérêt est de préférence d'orientation [100].

La couche tampon de matériau bidimensionnel ne comprenant pas de liaisons pendantes, elle peut fonctionner alors comme un substrat universel pour la croissance localisée du semi-conducteur d'intérêt avec une défectivité réduite (notamment une densité de dislocations émergeantes réduite) et donc présentant des propriétés physico-chimiques optimisées. En effet, contrairement à une croissance directe sur un substrat de silicium, la croissance sur la couche tampon de matériau bidimensionnel permet de s'affranchir de la problématique de différence de paramètres de maille. Elle se fait sans (ou avec très peu) de liaisons covalentes à l'interface, en favorisant une croissance de type van der Waals, permettant ainsi la formation d'un matériau non contraint, ce qui évite le processus de relaxation par génération de dislocations émergeantes. Ceci permet ainsi de former une couche d'un matériau semi-conducteur d'intérêt qui est un matériau cristallin présentant une densité de dislocations émergentes inférieure à 10⁶/cm². Le matériau semi-conducteur d'intérêt est de préférence un matériau monocristallin.

En outre, la croissance sélective, c'est-à-dire sans les tranchées entre les motifs de masquage, d'un matériau semi-conducteur 3D (GaAs, GaN,...) sur un matériau 2D permet de concentrer la nucléation sur un nombre très limité de zones du substrat : la densité de nucléation s'en trouve considérablement renforcée et permet notamment la croissance d'une couche continue d'un matériau 3D sur un matériau 2D.

La présente invention n'est pas limitée aux modes de réalisation précédemment décrits mais s'étend à tout mode de réalisation entrant dans la portée des revendications.

Parmi les nombreuses applications de l'invention, on peut citer la microélectronique, la photonique, les capteurs, les technologies en relation avec la radiofréquence, les microsystèmes électromécaniques (MEMS), les composants pour l'internet des objets (Internet of Things), les chargeurs de batterie, les composants haute-tension, microprocesseurs, les mémoires statique et dynamique, le photovoltaïque, et plus largement tout ce qui touche aux technologies « more than Moore » ou technologies dites dérivées, c'est-à-dire les technologies qui intègrent plusieurs fonctions sur une même puce de silicium.

## Revendications

1. Procédé d'hétéro-intégration d'un matériau semi-conducteur d'intérêt sur un substrat (1) de silicium **caractérisé en ce qu'**il comprend :
- une étape de structuration du substrat qui comprend une étape de réalisation d'un masque de croissance (2) à la surface du substrat (1) de silicium, ledit masque de croissance comprenant une pluralité de motifs de masquage (20), deux motifs de masquage étant séparés par une tranchée (21) dans laquelle le substrat (1) de silicium est découvert ;
- une étape de formation d'une couche tampon (5) bidimensionnelle en un matériau 2D, ladite couche tampon étant exempte de liaisons pendantes sur sa surface libre et étant formée sélectivement sur un plan (3) de silicium d'orientation [111] dans au moins une tranchée (21), ladite étape de formation d'une couche tampon étant réalisée après l'étape de structuration et étant réalisée par la technique de dépôt en phase vapeur aux organométalliques (MOCVD) ;
- une étape de formation d'au moins une couche (61, 62) d'un matériau semi-conducteur d'intérêt sur la couche tampon (5).

2. Procédé selon la revendication 1, le matériau semi-conducteur d'intérêt étant un matériau semi-conducteur IV-IV, III-V, II-VI et/ou un matériau semi-conducteur 2D.

3. Procédé selon l'une des revendications 1 ou 2, les motifs de masquage étant en un matériau diélectrique.

4. Procédé selon l'une des revendications 1 à 3, le substrat (1) de silicium étant un substrat (Si(001)) de silicium d'orientation [001] et l'étape de structuration comprenant en outre une étape de formation d'au moins une facette (31, 32) de silicium d'orientation [111] dans le substrat (1) de silicium, de manière à former au moins un plan (3) de silicium d'orientation [111], la facette étant réalisée à travers une tranchée (21).

5. Procédé selon la revendication 4, la facette présentant une surface inclinée d'un angle inférieur à 90° par rapport à la surface du substrat dans laquelle ladite facette est formée.

6. Procédé selon la revendication 5, deux facettes (31, 32) de silicium d'orientation [111] étant formées dans une tranchée (21), chaque facette présentant une surface inclinée d'un angle inférieur à 90° par rapport à la surface du substrat dans laquelle ladite facette est formée.

7. Procédé selon l'une quelconque des revendications précédentes comprenant en outre :
- une étape de passivation consistant en un dépôt d'un biplan atomique de gallium et de sélénium sur le plan (3) de silicium d'orientation [111] de manière à former une surface passivée (4) en silicium-gallium-sélénium sur ledit plan.

8. Procédé selon la revendication 7, l'étape de passivation étant réalisée entre l'étape de structuration et l'étape de formation de la couche tampon (5).

9. Procédé selon l'une quelconque des revendications 7 ou 8, dans lequel l'étape de formation d'au moins une couche tampon (5) consiste en une épitaxie de van der Waals et comprend :
- une première étape de nucléation d'un matériau 2D sur la surface passivée (4) ; et
- une première étape de croissance des nuclei (51) obtenus à l'issue de la première étape de nucléation.

10. Procédé selon l'une quelconque des revendications précédentes, l'étape de réalisation d'au moins une couche (61, 62) d'un matériau semi-conducteur d'intérêt consistant en une étape d'épitaxie supplémentaire comprenant :
- une seconde étape de nucléation du semi-conducteur d'intérêt sur la couche tampon (5) ; et
- une seconde étape de croissance de la couche de nucléation (6) obtenue à l'issue de la seconde étape de nucléation.

11. Procédé selon l'une quelconque des revendications précédentes, la largeur (l) d'une tranchée (21) étant inférieure ou égale à 20 µm, de préférence inférieure ou égale à 2 µm.

12. Procédé selon l'une quelconque des revendications précédentes, le matériau 2D de la couche tampon (5) étant choisi parmi le GaSe, le GaS, le GaTe, le MoS₂, le MoSe₂, le WS₂, le WSe₂, le InSe ou une combinaison desdits matériaux.

13. Procédé selon l'une quelconque des revendications précédentes, le matériau semi-conducteur d'intérêt étant choisi parmi le GaAs, GaSb, GaN, AlN.

14. Structure obtenue par le procédé d'hétéro-intégration selon l'une des revendications 1 à 13 et comprenant :
- un substrat (1) de silicium ;
- une pluralité de motifs de masquage (20) disposés sur le substrat (1) de silicium, deux motifs de masquage étant séparés par une tranchée (21) ;
- une couche tampon (5) bidimensionnelle disposée dans chaque tranchée (21) ;
- une couche (61, 62) d'un matériau semi-conducteur d'intérêt disposée sur la couche tampon (5) bidimensionnelle et au moins dans chaque tranchée (21), ladite couche d'un matériau semi-conducteur d'intérêt présentant une densité de dislocations émergentes inférieure à 10⁶/cm².

15. Structure selon la revendication 14, le matériau semi-conducteur d'intérêt étant un matériau semi-conducteur IV-IV, III-V, II-VI et/ou un matériau semi-conducteur 2D.

16. Structure selon l'une des revendications 14 ou 15 comprenant en outre une couche de passivation (4) en silicium-gallium-sélénium entre le substrat de silicium (1) et la couche tampon bidimensionnelle (5).

17. Structure selon l'une des revendications 14 à 16, la couche (62) d'un matériau semi-conducteur d'intérêt remplissant chaque tranchée (21) et s'étendant en outre en dehors de chaque tranchée, par exemple pour former un nanofil horizontal.

18. Structure selon l'une des revendications 14 à 17, le matériau semi-conducteur d'intérêt étant un matériau monocristallin.
